(19) Europäisches Patentamt / European Patent Office / Office européen des brevets

(11) **EP 2 204 659 B1**

(12) **FASCICULE DE BREVET EUROPEEN**

(45) Date de publication et mention de la délivrance du brevet:
**13.06.2018 Bulletin 2018/24**

(21) Numéro de dépôt: **10159262.4**

(22) Date de dépôt: **07.03.2008**

(51) Int Cl.:
*G01R 31/08* *(2006.01)*  *G01R 31/11* *(2006.01)*

(54) **Procédé et dispositif de localisation d'un défaut sur une liaison électrique**

Verfahren und Vorrichtung zur Fehlerlokalisierung in einer elektrischen Verbindung

Method and device for locating a fault in an electric link

(84) Etats contractants désignés:
**AT BE BG CH CY CZ DE DK EE ES FI FR GB GR HR HU IE IS IT LI LT LU LV MC MT NL NO PL PT RO SE SI SK TR**

(43) Date de publication de la demande:
**07.07.2010 Bulletin 2010/27**

(62) Numéro(s) de document de la (des) demande(s) initiale(s) en application de l'article 76 CBE:
**08290221.4 / 2 098 877**

(73) Titulaire: **RTE Réseau de Transport d'Electricité 92919 Paris La Défense Cedex (FR)**

(72) Inventeurs:
• **Surdon, Matthieu 92800 Puteaux (FR)**
• **Aucourt, Christian 59700, Marcq en Bareuil (FR)**
• **Bourgeat, Xavier 78400, Chatou (FR)**

(74) Mandataire: **Bonnet, Michel Cabinet Bonnet 93, rue Réaumur - Boîte 10 75002 Paris (FR)**

(56) Documents cités:
CH-A- 386 557   FR-A1- 2 766 274
US-A- 4 835 478   US-A1- 2002 130 668
US-A1- 2006 232 259

**EP 2 204 659 B1**

## Description

La présente invention concerne un procédé, un dispositif et une installation de localisation d'un défaut sur une liaison électrique. Par liaison électrique, on entend une liaison comportant un câble électrique ou une pluralité de câbles électriques reliés entre eux.

L'invention s'applique notamment à la localisation de défauts dans des câbles de transport d'énergie électrique dans des liaisons incluant par exemple des câbles électriques sous-marins et/ou souterrains, pour lesquels il est difficile d'intervenir et donc nécessaire d'obtenir une localisation précise et fiable.

Plus précisément l'invention concerne un procédé comprenant les étapes consistant à émettre, à un premier instant, un signal électrique à vitesse prédéterminée de propagation au départ d'une extrémité de la liaison électrique, et à détecter, à un second instant, la réception d'un écho de ce signal électrique.

Un tel procédé est décrit dans la demande de brevet français publiée sous le numéro FR 2 784 192. Dans ce document, le procédé décrit est présenté comme s'appliquant notamment à des câbles de réseaux de télécommunication. Un signal impulsionnel est tout d'abord émis à une première extrémité d'un câble présentant un défaut. Puis des échos successifs, dus aux réflexions multiples du signal impulsionnel sur le défaut après plusieurs allers et retours entre la première extrémité et le défaut, sont reçus et visualisés à l'écran d'un oscilloscope. A vitesse de propagation V constante, si le retour du premier écho est détecté au bout d'un temps t suite à l'émission du signal impulsionnel, on en déduit la longueur L de câble traversée entre la première extrémité du câble et le défaut, à l'aide de la relation de proportionnalité

suivante : $L = \dfrac{V}{2}t$. Sur l'oscilloscope, l'axe des abscisses peut donc être directement gradué en mètres au lieu de microsecondes étant donné que la vitesse de propagation du signal impulsionnel le long du câble est connue. En effet, selon une propriété avantageusement exploitée dans ce document, les caractéristiques internes du câble de réseau de télécommunication comportant le défaut sont très homogènes sur toute sa longueur et le milieu externe n'a pas d'influence sur la propagation à l'intérieur du câble, de sorte que la vitesse de propagation du signal impulsionnel dans le câble peut être considérée comme connue et constante. Ainsi, un opérateur est capable de lire directement sur l'oscilloscope, sans calcul supplémentaire, la distance L entre la première extrémité du câble et le défaut.

Malheureusement, ce procédé, appliqué à la localisation ou à la pré localisation de défauts dans des liaisons de transport d'énergie électrique, notamment des câbles isolés d'énergie sous-marins ou souterrains, ou bien une combinaison de ces deux types de câbles, ne donne pas de résultat précis. Il a été ainsi constaté que l'erreur de localisation peut atteindre plus d'un kilomètre pour un câble sous-marin de moins de cinquante kilomètres. C'est très pénalisant puisque, justement pour ce type de câbles dont la longueur se compte souvent en dizaines de kilomètres, la difficulté pour intervenir en réparation d'un défaut exige une fiabilité importante du résultat.

Les documents US2002/0130668 et US2006/0232259 divulguent d'autres appareils.

L'invention a pour objet un procédé de localisation d'un défaut sur une liaison électrique selon la revendication 1 et un dispositif correspondant selon la revendication 10. Des modes de réalisation préférés sont indiqués dans les revendications dépendantes 2 à 9. Selon un mode de réalisation, les mesures, à plusieurs endroits le long de la liaison, d'au moins une partie des composantes du champ électromagnétique sont réalisées selon un trajet constitué de passages transversaux successifs à l'aplomb de la liaison, notamment selon un tracé en boustrophédon.

Selon un mode de réalisation, le champ électromagnétique mesuré est généré par la circulation dans la liaison électrique d'un courant de fréquence prédéterminée et dans lequel la partie mesurée des composantes du champ électromagnétique est filtrée à l'aide d'un système de filtrage passe-bande réglé autour de cette fréquence prédéterminée du courant.

L'invention sera mieux comprise à l'aide de la description qui va suivre, donnée uniquement à titre d'exemple et faite en se référant aux dessins annexés dans lesquels :

- la figure 1 représente schématiquement et partiellement la structure d'une installation de transmission d'énergie électrique, par câbles isolés souterrain et sous-marin, munie de dispositifs de localisation d'un défaut,
- la figure 2 représente schématiquement et en coupe un câble isolé sous-marin de transmission d'énergie électrique présentant un défaut,
- les figures 3a et 3b illustrent graphiquement les variations corrélées d'un facteur de pertes diélectriques et d'une permittivité diélectrique dans les câbles de la figure 1 en fonction de la distance parcourue par un signal dans ces câbles,
- les figures 4a et 4b illustrent graphiquement plusieurs modèles simplifiés de variation de la vitesse de propagation d'un signal électrique dans les câbles de la figure 1 en fonction de la longueur de câble parcourue par ce signal,
- la figure 5 illustre graphiquement l'allure générale d'un écho de signal électrique détecté à une extrémité des câbles de la figure 1,
- la figure 6 illustre les étapes successives d'un procédé de localisation de défaut,

- la figure 7 représente schématiquement une installation pour la mise en oeuvre d'un procédé de localisation de défaut selon l'invention,
- la figure 8 représente schématiquement un dispositif de mesure de l'installation de la figure 7,
- la figure 9 illustre graphiquement un principe de mesure mis en oeuvre par le dispositif de la figure 8,
- la figure 10 illustre les étapes successives du procédé de localisation de défaut mis en oeuvre par l'installation de la figure 7, et
- la figure 11 représente schématiquement la réalisation d'une étape particulière du procédé de localisation de défaut mis en oeuvre par l'installation de la figure 7.

## Localisation ou pré-localisation d'un défaut par échométrie

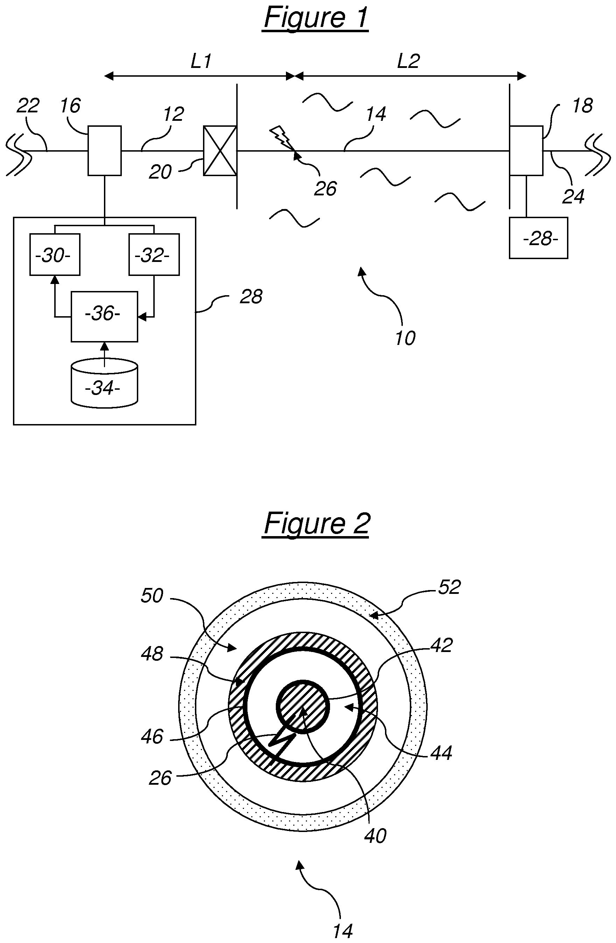

L'installation 10 de transmission d'énergie électrique de la figure 1 comporte une liaison électrique comportant deux câbles électriques 12 et 14 connectés entre eux bout à bout. Le câble 12 est un câble souterrain, tandis que le câble 14 est un câble sous-marin. A titre d'exemple, il sera considéré dans la suite de la description que cette installation illustre schématiquement et partiellement un bi-pôle de la liaison IFA2000 dont une première extrémité 16, dite extrémité de Sellindge, est située en Grande-Bretagne et dont la seconde extrémité 18, dite extrémité de Sangatte, est située en France. Les câbles 12 et 14 sont connectés entre eux à l'aide d'une jonction 20, dite jonction de Folkestone, située en Grande-Bretagne. En réalité un bi-pôle de la liaison IFA2000 comporte deux paires de câbles tels que l'ensemble constitué des câbles 12 et 14, mais la représentation simplifiée de la figure 1 suffit pour comprendre le principe. Le câble sous-marin 14, d'une longueur d'environ 44,6 kilomètres, relie l'extrémité de Sangatte 18 à la jonction de Folkestone 20. Le câble souterrain 12, d'une longueur d'environ 18,5 kilomètres, relie la jonction de Folkestone 20 à l'extrémité de Sellindge. Ces câbles 12 et 14 permettent de relier deux réseaux 22, 24 de transport et de distribution d'énergie électrique en Grande-Bretagne et en France.

Lorsqu'un défaut 26 apparaît dans l'un des câbles 12 ou 14, ici le câble sous-marin 14, à une distance L1, le long du câble, de l'extrémité de Sellindge 16 et L2 de l'extrémité de Sangatte 18, un procédé de localisation de ce défaut consiste à injecter un signal impulsionnel dans la liaison électrique et à détecter le retour d'un écho de ce signal après réflexion sur le défaut. La jonction de Folkestone ne pouvant pas être ouverte, il est possible d'injecter ce signal impulsionnel uniquement à partir de l'extrémité de Sellindge 16 ou de Sangatte 18.

Pour cela, au moins un dispositif de localisation 28 est raccordé à l'installation, soit au niveau de l'extrémité de Sellindge 16, soit au niveau de l'extrémité de Sangatte 18, soit à chacune de ces deux extrémités. Dans l'exemple illustré par la figure 1, deux dispositifs de localisation 28 sont raccordés respectivement aux deux extrémités 16 et 18.

Chacun de ces dispositifs de localisation comporte :

- un générateur 30 de signal pour l'émission, à un premier instant, d'un signal électrique à vitesse prédéterminée $V_0$ de propagation au départ d'une extrémité 16 ou 18 de l'ensemble de câbles 12, 14,
- un récepteur 32 de signal pour la détection, à un second instant, de la réception d'un écho de ce signal électrique à cette même extrémité 16 ou 18,
- des moyens 34 de stockage de données issues d'un modèle de variation de la vitesse de propagation du signal électrique dans l'ensemble de câbles 12, 14 en fonction de la longueur de câble parcourue par le signal, et
- un calculateur 36, configuré pour estimer une localisation du défaut 26 à l'aide des données stockées, en fonction de la différence entre les premier et second instants, de la vitesse prédéterminée de propagation et du modèle de variation de vitesse dans l'ensemble de câbles 12, 14.

L'ensemble constitué des moyens de stockage 34 et du calculateur 36 peut être en pratique un simple ordinateur apte à commander le générateur 30 et à traiter des signaux fournis par le récepteur 32. L'ensemble constitué du générateur 30 et du récepteur 32 peut être en pratique un échomètre classique. Ainsi, chaque dispositif de localisation 28 peut être constitué d'un échomètre commandé par un ordinateur.

Sur la figure 2, le câble sous-marin 14, de forme générale cylindrique, est représenté en coupe au niveau du défaut 26. Il comporte une âme conductrice 40, par exemple en cuivre, entourée d'un semi-conducteur interne 42, puis d'un isolant 44 constitué, pour la liaison IFA2000, de rubans de papier imprégné d'huile. L'isolant 44 est lui-même également entouré d'un semi-conducteur externe 46. Le semi-conducteur interne 42 est par exemple constitué de rubans de papier chargés de carbone et le semi-conducteur externe 46, de toile métallisée.

Cet ensemble est entouré d'un écran conducteur 48, par exemple en plomb, puis d'une gaine 50, puis enfin d'une armure en acier 52 pour la tenue et la protection mécanique du câble 14.

On notera que le câble représenté sur la figure 2 est présenté à titre purement illustratif et non limitatif. L'exemple s'applique à tout type de câbles électriques dits « isolés », y compris ceux qui ne comportent pas d'armure.

Le défaut 26 apparaît lorsque l'isolant 44 n'assure plus correctement sa fonction, de sorte qu'une partie du courant transporté passe entre l'âme conductrice 40 et l'écran 48. Ce passage axial de courant brûle l'isolant 44 et réalise alors un court-circuit entre l'âme et l'écran.

C'est ce court-circuit qui produit une singularité d'impédance, permettant la localisation du défaut 26 par échométrie.

Bien que la vitesse $V_0$ de propagation d'un signal impulsionnel au départ d'une extrémité 16 ou 18 de l'ensemble de câbles 12, 14 soit connue, considérer que cette vitesse est la vitesse constante de propagation du signal entre l'extrémité et le défaut, puis, après réflexion, entre le défaut et l'extrémité, conduit à des erreurs de mesure. En effet, une telle simplification suppose que les pertes diélectriques sont négligeables, mais aussi que le facteur de pertes diélectriques et la permittivité diélectrique de l'isolant 44 sont indépendants des fréquences du spectre du signal impulsionnel.

Or une étude analytique, corrélée avec des mesures effectuées sur les câbles 12 et 14, montre que le facteur de pertes diélectriques de l'isolant 44 varie avec la fréquence du signal, de sorte qu'un signal impulsionnel subit des distorsions par pertes variables sur ses composantes fréquentielles. Le tableau ci-dessous donne les caractéristiques des câbles 12 et 14.

| | Câble 14 | Câble 12 |
|---|---|---|
| Diamètre sur conducteur (mm) | 35 | 40,2 |
| Résistivité du conducteur ($\Omega$.m) | $1,7241.10^{-8}$ | $1,7241.10^{-8}$ |
| Diamètre du canal central (mm) | | 20 |
| Diamètre sur écran extérieur (mm) | 68,8 | 67,8 |
| Epaisseur de l'écran (mm) | 3,2 | 3,1 |
| Résistivité de l'écran ($\Omega$.m) | $21,4.10^{-8}$ | $21,4.10^{-8}$ |
| Facteur de perte ($\times 10^{-4}$) en fonction de la fréquence exprimée en kHz | | |
| $10^{-2}$ | 20,9 | 19,5 |
| $3,2. 10^{-2}$ | 27,6 | 26,4 |
| $10^{-1}$ | 30,4 | 31,0 |
| $3,2. 10^{-1}$ | 32,4 | 39,9 |
| 1 | 36,7 | 65,7 |
| 3,2 | 49,3 | 144,4 |
| 10 | 86,8 | 348,8 |
| 32 | 166,4 | 690,2 |
| $10^2$ | 253,5 | 921,7 |
| $3,2. 10^2$ | 300,0 | 851,6 |
| $0^3$ | 311,8 | 566,4 |
| $3,2. 10^3$ | 291,3 | 331,3 |
| $10^4$ | 226,1 | 179,4 |
| $3,2. 10^4$ | 139,2 | 89,9 |
| $10^5$ | 74,1 | 50,1 |
| $3,2. 10^5$ | 41,5 | 34,2 |
| $10^6$ | 24,7 | 23,4 |

Par ailleurs, des mesures effectuées sur les câbles 12 et 14 montrent également que la permittivité diélectrique de l'isolant 44 varie de façon corrélée avec le facteur de pertes. En fait, lors de sa propagation dans les câbles 12 et 14, un signal s'appauvrit de ses composantes à hautes fréquences, de sorte que la réponse du diélectrique n'est pas constante en fonction de la distance parcourue par le signal. En particulier, les pertes diélectriques diminuent avec la distance parcourue par le signal, mais corrélativement la permittivité diélectrique de l'isolation augmente induisant, en même temps, une diminution de la vitesse de propagation du signal.

Une estimation de la variation de la vitesse de propagation d'un signal en fonction de la distance parcourue, dans les câbles 12 et 14, peut être menée par une étude purement analytique, suivie d'une résolution numérique selon une représentation choisie, par exemple une représentation de Laplace ou de Fourier.

L'approche purement analytique permet de dégager les aspects physiques de la propagation des composantes spectrales d'un signal dans un câble. Elle met en relief le rôle de l'inductance L et de la perditance G du câble dans l'affaiblissement du signal. Cet affaiblissement se traduit par un retard dans l'arrivée d'un écho de ce signal par rapport à un signal qui se propagerait dans un milieu sans pertes.

Selon cette étude, la réponse $\sigma(x, t)$ d'un câble, à une distance x de l'origine de l'émission et après un temps t, à un signal peut être considérée comme la somme sur tout le domaine des fréquences ou des pulsations $\omega$ (de 0 à l'$\infty$) des solutions sinusoïdales particulières $v(\omega)$ de l'Equation des Télégraphistes. Si l'on considère les constantes R, L, C et G du câble indépendantes de la fréquence, la réponse $\sigma(x,t)$ du câble comporte alors une onde frontale et une queue de signal, chaque composante spectrale ne se propageant pas avec la même vitesse $w(\omega)$. Les composantes $v(\omega)$ dont les fréquences sont les plus élevées forment un paquet d'ondes qui se propage à une vitesse limite W définie par $W = \dfrac{1}{\sqrt{LC}}$ et constituent l'onde frontale. Cette onde frontale reproduit sans déformation, mais avec un affaiblissement, le signal émis. Cependant les constantes R, L et G du câble varient avec la fréquence. Notamment, la variation de R et L avec la fréquence donne naissance à une onde résiduelle dans l'onde frontale, laquelle ne reproduit donc plus le signal émis. C'est le refoulement du courant à la surface des conducteurs, aux hautes fréquences, qui en est physiquement à l'origine.

La réponse $\sigma(x, t)$ du câble, limitée à l'onde frontale, est alors définie par une expression de la forme :

$$(1) \qquad \sigma(\mathrm{x}, \mathrm{t}) = \mathrm{A} . \mathrm{e}^{-a\theta} . \left[ \mathrm{erfc}\, \chi(\mathrm{t}) - \gamma(\mathrm{t} - \mathrm{t}_0) \mathrm{erfc}\, \chi(\mathrm{t} - \mathrm{t}_0) \right] ,$$

avec $\chi(\mathrm{t}) = \sqrt{\dfrac{\tau}{2\,\mathrm{t}}}$ , $\tau$ étant une constante de temps, et où la fonction erfc est la fonction d'erreur complémentaire

définie par $erfc(z) = \dfrac{2}{\pi} \int\limits_0^z e^{-t^2} dt$ .

La perditance G se confond avec la conductance de pertes diélectriques, soit $G = C\omega\mathrm{tg}(\delta)$. Elle contribue à amoindrir notablement la contribution des composantes haute fréquence à la formation l'écho du signal et se traduit par un retard apparent de l'arrivée de l'écho égal à $\left( \dfrac{\mathrm{tg}(\delta)}{2} \right).\theta_0$ .

Cependant, les effets liés à la perditance G et à l'inductance L du câble ne peuvent pas, seuls, rendre compte des variations effectives mesurables de la vitesse de propagation dans le câble. Conformément à des mesures effectuées, un postulat est établi pour modéliser la propagation du signal, consistant à prendre en compte le lien nécessaire entre les variations, avec la fréquence, du facteur de pertes diélectriques $\mathrm{tg}(\delta)$ de l'isolant 44, et de sa permittivité diélectrique $\varepsilon$r, dans une résolution numérique du modèle analytique décrit ci-dessus, permettant d'accéder à la forme et aux caractéristiques de l'écho et de rendre compte de la vitesse de propagation du signal. Deux approches numériques possibles, l'une selon une représentation de Laplace, l'autre selon une représentation de Fourier, permettent de résoudre le modèle analytique et fournissent des résultats légèrement différents, à confronter avec les mesures.

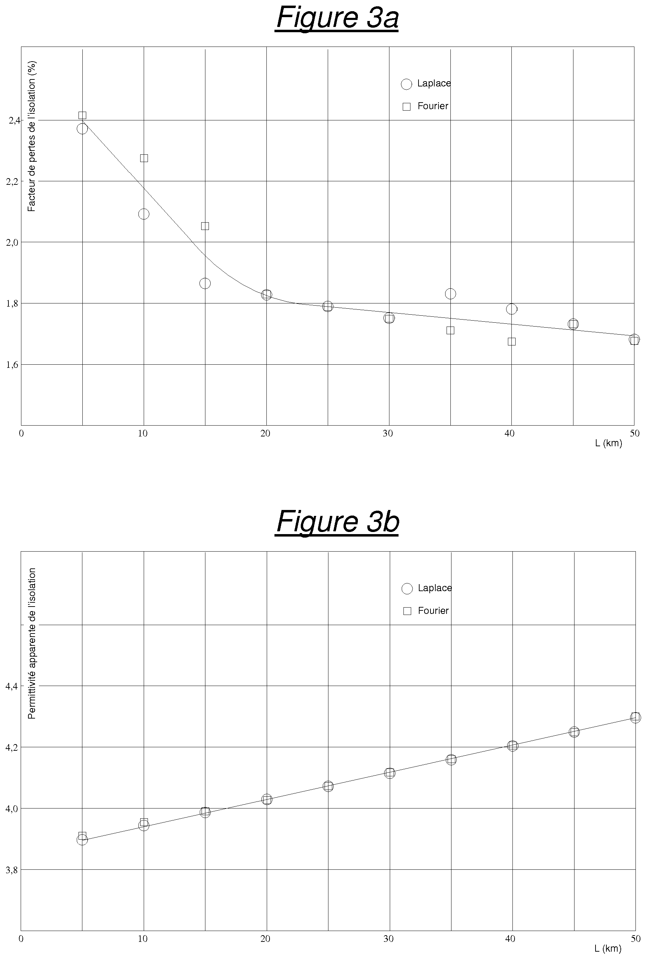

Les résultats de l'analyse numérique donnent notamment un support quantitatif aux variations du facteur de pertes diélectriques $\mathrm{tg}(\delta)$ de l'isolant et de sa permittivité diélectrique $\varepsilon$r avec la distance L parcourue par le signal, représentées dans les figures 3a et 3b pour le câble sous-marin 14, l'extrémité de Sangatte 18 définissant l'origine des émissions. On remarque que, si les représentations de Laplace et Fourier conduisent aux mêmes estimations de variation de la permittivité diélectrique de l'isolant en fonction de la distance parcourue par le signal, il n'en est pas tout à fait de même pour les estimations de variation du facteur de pertes diélectriques $\mathrm{tg}(\delta)$.

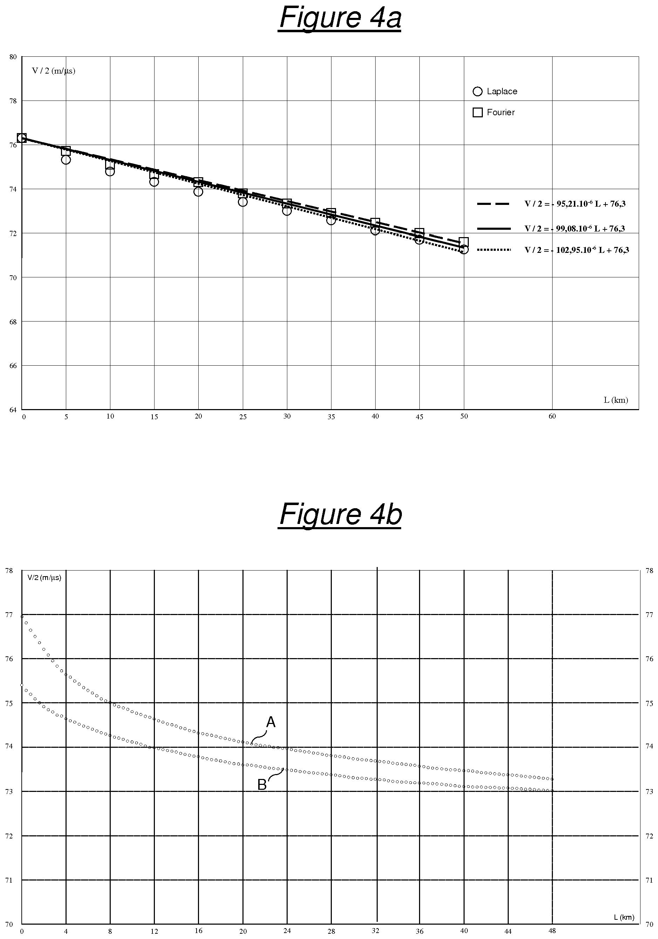

Il en résulte plusieurs modèles possibles de variation de la vitesse V de propagation dans le câble sous-marin 14, comme cela est représenté sur la figure 4a. Par exemple, un premier modèle, celui utilisant une représentation de Laplace, est illustré par des valeurs identifiées par des cercles et est réduit linéairement selon une droite en traits interrompus courts. Un deuxième modèle, celui utilisant une représentation de Fourier, est illustré par des valeurs identifiées par des carrés et est réduit linéairement selon une droite en traits interrompus long. Un troisième modèle, résultant de mesures réalisées sur le câble 14, est illustré par une droite en trait continu. La vitesse de propagation à l'émission dans le câble sous-marin 14, 152,6 m/$\mu$s, est connue et est commune aux trois modèles. Les pentes des trois droites sont voisines, témoignant de la convergence des approches analytiques de Laplace et de Fourier, ainsi que de la pertinence du postulat selon lequel les variations, avec la fréquence, du facteur de pertes diélectriques tg($\delta$) de l'isolant 44 et de sa permittivité diélectrique $\varepsilon$r sont liées.

Sur la figure 4b, les deux formalismes de Laplace et Fourier ayant donné des résultats convergents visibles sur la figure 4a, l'Equation des Télégraphistes est traitée uniquement selon le formalisme de Fourier, en incluant un modèle de variation des pertes et de la permittivité de l'isolant 44 avec la fréquence et donc en fonction de la distance parcourue par un signal, dans deux situations de mesure par échométrie :

- une mesure par échométrie depuis l'extrémité de Sangatte 18 (courbe A), et
- une mesure par échométrie depuis l'extrémité de Sellindge 16, en incluant la présence de deux types de câbles 12 et 14 (courbe B).

On notera que la vitesse effective du signal et de son écho après réflexion sur le défaut 26 est déduite, par l'Equation des Télégraphistes, du calcul du temps $\theta$ de leur propagation entre le dispositif de mesure 28 et le défaut, la longueur L du câble étant connue par hypothèse.

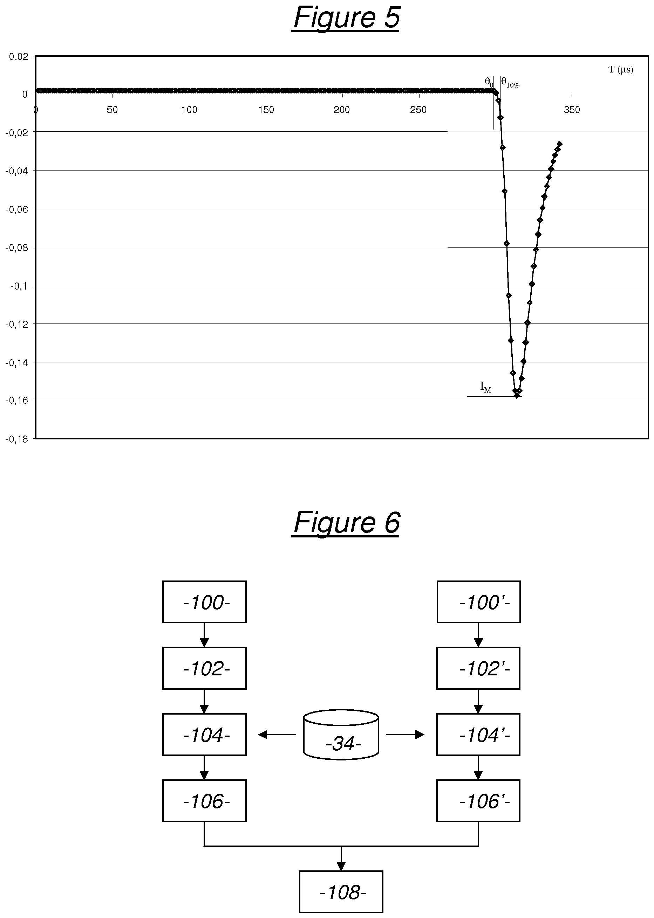

Le temps de propagation est l'intervalle de temps entre l'émission du signal repéré par son front d'onde à faible temps de montée, et la réception de son écho sur le défaut, par exemple repéré par le pied $\theta_0$ de la « tête de signal » à temps de montée de plusieurs ordres de grandeur plus élevés. Le pied de l'écho $\theta_0$ présente une difficulté de localisation, en raison de la forte atténuation des composantes de rang plus élevé du signal et de son écho sur le défaut. Il peut être cependant repéré par l'étude des données relatives à l'amplitude de l'écho, notamment la variation de courbure de la courbe représentative. En variante, le temps de propagation peut être mesuré au niveau de l'abscisse à 10% d'amplitude maximale de l'écho, notée $\theta_{10\%}$ comme cela est représenté sur la figure 5. Le modèle de variation de la vitesse de propagation est évidemment dépendant du repère choisi.

En reprenant un modèle linéaire de variation de la vitesse de propagation, comme illustré par la figure 4a, on admet la relation suivante :

$$(2) \qquad V/2 = V_0/2 - L/\tau.$$

On en déduit la relation générale donnant la distance, le long du câble, du défaut par rapport au point de mesure en fonction du temps de propagation $\theta$ mesuré :

$$(3) \qquad L = \frac{V_0/2}{1/\theta + 1/\tau} \, ,$$

avec, pour le câble 14, $V_0/2 = 76{,}3$ m/$\mu$s et $1/\tau = 88{,}0.10^{-6}$ $\mu$s$^{-1}$ si $\theta = \theta_0$ et $1/\tau = 99{,}08.10^{-6}$ $\mu$s$^{-1}$ si $\theta = \theta_{10\%}$ (exemple de la figure 4a).

La valeur de $V_0/2$ est considérée connue, c'est-à-dire sans incertitude. L'incertitude de la relation (3) réside donc dans la pente $1/\tau$ et dans la mesure $\theta$. On en déduit la relation d'incertitude suivante :

$$(4) \qquad \frac{\Delta L}{L} = \frac{1}{1 + \theta/\tau} \left( \frac{\theta}{\tau} \cdot \frac{\Delta \tau}{\tau} + \frac{\Delta \theta}{\theta} \right).$$

Les modèles de vitesse de propagation de la figure 4a sont en fait basés sur une mesure du temps de propagation à $\theta_{10\%}$ et montrent qu'il existe effectivement une incertitude mesurable dans la pente $1/\tau$ en plus de l'incertitude sur la mesure $\theta$. Cette incertitude peut être majorée, selon les mesures et résolutions numériques de la figure 4a par la valeur suivante :

$$(5) \qquad \frac{\Delta \tau}{\tau} = 3{,}903 \, \% \, .$$

Des modèles de vitesse de propagation basés sur une mesure du temps de propagation à $\theta_0$ montreraient

qu'il n'existe pas d'incertitude dans la pente $1/\tau$ et que seule existe une incertitude sur la mesure dans ce cas.

Dans le cas de mesures à $\theta_0$, le terme $\dfrac{\Delta\tau}{\tau}$ est donc nul et la relation (4) devient :

$$\frac{\Delta L}{L} = \frac{1}{1 + \theta/\tau} \cdot \frac{\Delta\theta}{\theta} \leq \frac{\Delta\theta}{\theta},$$

le terme $\theta/\tau$ pouvant être considéré comme faible devant 1. Des mesures effectuées sur le câble 14 établissent l'incertitude relative $\dfrac{\Delta\theta}{\theta}$ à 1,236 %.

Dans le cas de mesures à $\theta_{10\%}$, le terme $\dfrac{\Delta\tau}{\tau}$ n'est pas nul (il peut être majoré par la valeur 3,903 %) et, multiplié par $\theta/\tau$ est de l'ordre de 0,18 %. Ainsi, si l'on suppose que l'opérateur est susceptible d'effectuer une mesure de $\theta_{10\%}$ avec une incertitude relative sur l'origine de référence inférieure ou égale à 1%, le choix de cette mesure est justifié. Pour une mise en oeuvre simple et rapide du procédé de localisation du défaut 26, de la relation (3) on peut directement construire un tableau de correspondance entre la distance L du défaut 26 à un point de référence et le temps total mesuré de propagation aller-retour du signal émis et de son écho. Ce tableau est stocké dans les moyens de stockage 34.

A titre d'exemple, pour la liaison IFA2000, les tableaux de correspondance fournis en annexe ont été conçus :

- tableau 1 : pour une échométrie réalisée depuis l'extrémité de Sangatte 18, le tableau 1 donne une correspondance entre la distance L du défaut à cette extrémité de Sangatte et le temps total de propagation aller-retour (par mesure $\theta_0$ ou $\theta_{10\%}$),
- tableau 2 : pour une échométrie réalisée depuis l'extrémité de Sellindge 16, le tableau 2 donne une correspondance entre la distance L du défaut à la jonction de Folkestone 20 et le temps total de propagation aller-retour (par mesure $\theta_0$ ou $\theta_{10\%}$).

On notera bien sûr que les valeurs données dans ce tableau sont relatives à une valeur prédéterminée fixée de la vitesse $V_0$ d'émission du signal.

Le procédé de localisation du défaut 26 illustré sur la figure 6 est mis en oeuvre dans l'installation de la figure 1.

Il comporte une première étape 100 d'émission, à partir d'un premier dispositif de localisation 28 disposé à l'extrémité de Sangatte 18, d'un signal impulsionnel à un instant t = 0 pris comme repère de l'axe des temps.

Ensuite, lors d'une deuxième étape de mesure 102, un écho représentatif de la réflexion de ce signal sur le défaut 26 est détecté, soit automatiquement, soit manuellement par un opérateur. L'instant $\theta_0$ ou $\theta_{10\%}$ de réception de cet écho est mesuré, soit au pied de l'écho, soit à 10 % de l'amplitude maximale de l'écho, comme indiqué précédemment.

Lors d'une étape d'estimation 104, l'instant de réception de l'écho est comparé aux valeurs du tableau 1, en deuxième ou troisième colonne selon la mesure, pour en déduire, par correspondance, un segment de câble de 400 mètres de longueur dans lequel se trouve le défaut 26 d'après la mesure. Une estimation plus précise de la position du défaut à l'intérieur du segment de câble peut être obtenue par interpolation linéaire, selon un calcul connu, en fonction des extrémités de ce segment de câble et de la position de l'instant de réception mesuré dans le segment temporel correspondant du tableau 1.

Enfin, lors d'une dernière étape 106, la valeur estimée de localisation du défaut est retournée.

En variante, la localisation peut être réalisée depuis l'extrémité de Sellindge 16. Dans ce cas également, la vitesse $V_0$ d'émission du signal est fixée et connue.

Dans ce cas, le procédé de localisation comporte une première étape 100' d'émission, à partir d'un premier dispositif de localisation 28 disposé à l'extrémité de Sellindge 16, d'un signal impulsionnel à un instant t = 0 pris comme repère de l'axe des temps.

Ensuite, lors d'une deuxième étape de mesure 102', un écho représentatif de la réflexion de ce signal sur le défaut 26 est détecté, soit automatiquement, soit manuellement par un opérateur. L'instant $\theta_0$ ou $\theta_{10\%}$ de réception de cet écho est mesuré, soit au pied de l'écho, soit à 10 % de l'amplitude maximale de l'écho, comme indiqué précédemment.

Lors d'une étape d'estimation 104', l'instant de réception de l'écho est comparé aux valeurs du tableau 2, en deuxième ou troisième colonne selon la mesure, pour en déduire, par correspondance, un segment de câble de 400 mètres de longueur dans lequel se trouve le défaut 26 d'après la mesure. Une estimation plus précise de la position du défaut à l'intérieur du segment de câble peut être obtenue par interpolation linéaire en fonction des extrémités de ce segment de câble et de la position de l'instant de réception mesuré dans le segment temporel correspondant du tableau 2.

Enfin, lors d'une dernière étape 106', la valeur estimée de localisation du défaut est retournée.

En variante et de façon optionnelle, deux dispositifs de localisation peuvent être disposés dans l'installation 10, chacun à une extrémité, et les étapes 100 à 106 d'une part, et 100' à 106' d'autre part, peuvent être exécutées de manière à obtenir deux valeurs estimées de localisation du défaut 26. Dans ce cas, les étapes 106 et 106' sont suivie d'une étape supplémentaire 108 lors de laquelle une estimation définitive de la localisation du défaut 26 peut être déduite des deux valeurs issues des étapes 106 et 106', avec éventuellement une incertitude estimée sous la forme d'un segment du câble 14.

**L'invention : localisation du défaut par étude d'un champ électromagnétique à l'aplomb du défaut**

Selon l'invention, suite par exemple à une pré-localisation réalisée comme précédemment décrit, c'est-à-dire par exemple suite à l'étape 108, une localisation plus fine par étude des variations du champ électromagnétique à l'aplomb du câble sous-marin 14 peut être menée au voisinage du segment de câble déterminé à l'étape 108. En effet, à cause de la présence du défaut 26 sur le câble sous-marin 14, un signal électrique de courant i émis à une certaine fréquence depuis une extrémité du câble dans l'âme conductrice 40 revient partiellement à sa source, au niveau du défaut 26, entre autre par la mer, créant ainsi une dissymétrie entre l'extrémité d'émission du courant et le défaut 26, alors qu'au delà du défaut cette dissymétrie n'existe plus. Ainsi, en mesurant le champ électromagnétique H à l'aplomb du câble 14 en amont du défaut 26 (c'est-à-dire entre l'extrémité d'émission et le défaut) et en s'approchant de ce défaut, le champ diminue puis s'annule, de sorte qu'une détection de la localisation du défaut peut se faire par détection de la variation puis de l'annulation du champ électromagnétique. La fréquence du signal électrique émis est par exemple située entre 25 et 80 Hz, en évitant les fréquences autour de 50 Hz qui correspondent aux fréquences parasites habituelles.

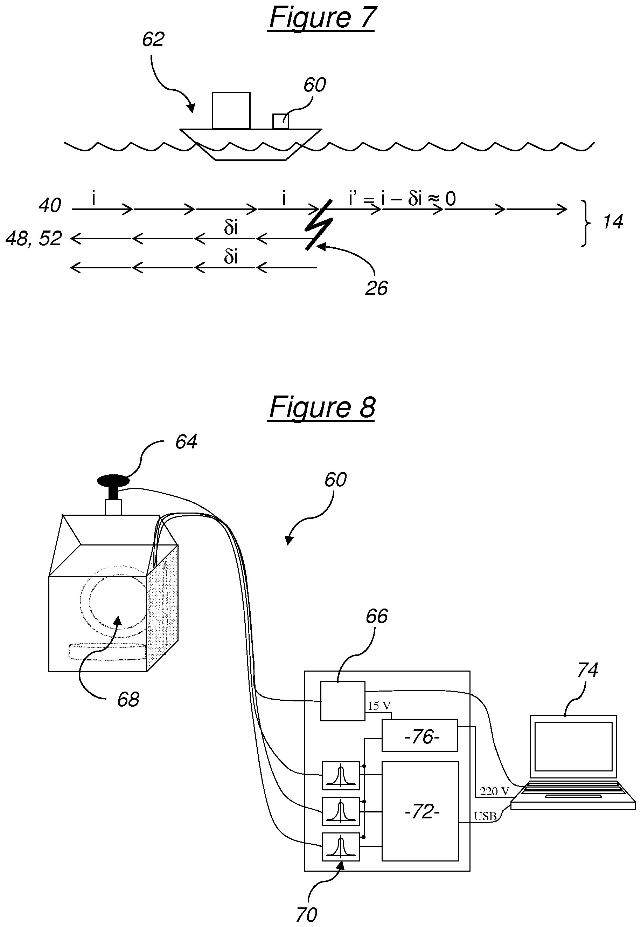

La mise en oeuvre de l'invention peut être réalisée par une installation telle que celle représentée sur la figure 7. Un dispositif 60 de mesure de champ électromagnétique est disposé sur un support flottant 62, par exemple un bateau, au voisinage de l'aplomb du défaut 26. Le bateau 62 se déplace, si possible le long du câble 14, et une mesure du champ est enregistrée régulièrement.

Comme représenté sur la figure 8, le dispositif 60 de mesure de champ électromagnétique comporte une antenne GPS 64 de positionnement géographique par satellite reliée à un boîtier GPS 66 de détection de positionnement géographique par satellite. Cela permet de connaître à chaque instant la position exacte du boîtier.

Par ailleurs, le dispositif 60 comporte 3 bobines 68 orthogonales entre elles, permettant la mesure de trois composantes orthogonales du champ électromagnétique, de manière à pouvoir en déduire une valeur du module complet |H| du champ H quelles que soient les fluctuations du bateau 62.

Les mesures de composantes du champ électromagnétique par les trois bobines 68 sont soumises à un filtrage, à l'aide de trois filtres passe-bande 70 d'ordre important autour de la fréquence du signal électrique émis. Le résultat de ces filtrages est ensuite soumis à une carte d'acquisition numérique 72.

Les valeurs de positionnement géographique du dispositif de mesure et de composantes du champ électromagnétique sont transmises, par le boîtier 66 et par la carte d'acquisition 72, à un ordinateur 74 pour l'exploitation de ces résultats. On notera que, comme le dispositif 60 de mesure de champ électromagnétique est un système embarqué, une alimentation 76 fournit le boîtier 66, le système de filtres 70 et l'ordinateur 74 en énergie électrique. A l'aide des trois composantes filtrées du champ électromagnétique, l'ordinateur reconstitue une valeur du module |H| de ce champ. Eventuellement, l'ordinateur extrait la composante verticale |Hz| du champ électromagnétique si les mesures prises le permettent.

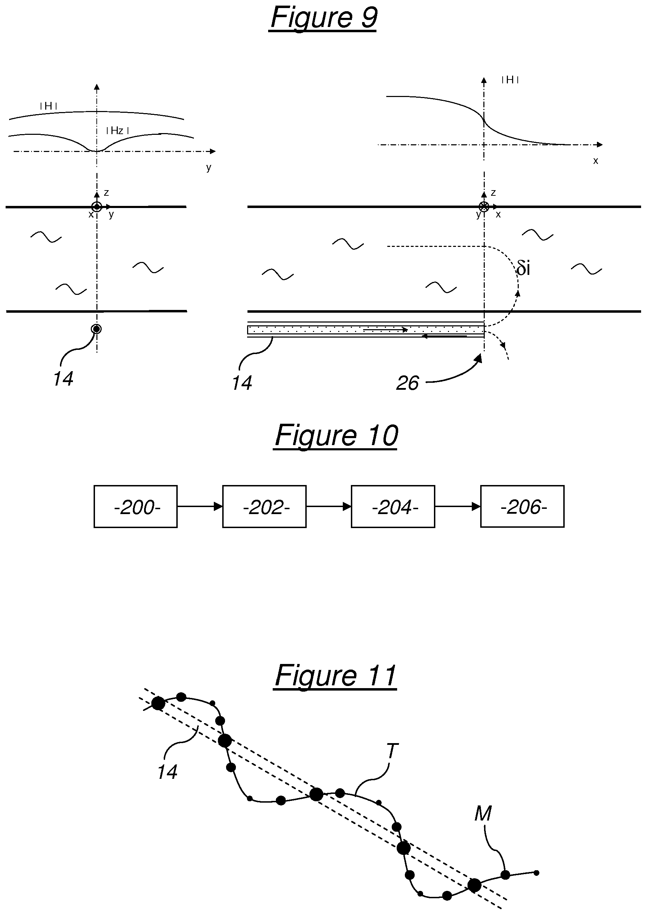

Le principe de localisation du défaut 26 mis en oeuvre par le dispositif 60, et plus particulièrement par l'ordinateur 74 est illustré sur la figure 9. On remarque qu'à hauteur (z) constante par rapport au fond marin, si l'on se déplace transversalement par rapport au câble 14, le module |H| du champ électromagnétique atteint un maximum à l'aplomb du câble. En revanche, sa composante verticale |Hz| atteint un minimum à l'aplomb du câble 14. En outre, on remarque qu'à hauteur (z) constante par rapport au fond marin, si l'on se déplace longitudinalement par rapport au câble 14, le module |H| du champ électromagnétique tend à diminuer à l'approche du défaut 26, puis à s'annuler une fois le défaut dépassé. A l'aplomb du défaut 26, la courbe donnant la valeur du module du champ le long du câble présente un point d'inflexion qui fournit donc une bonne estimation de la localisation du défaut 26.

On en déduit un procédé de localisation précise du défaut 26 sur le câble sous-marin 14, représenté sur la figure 10.

Lors d'une première étape 200, le bateau effectue un trajet T constitué de passages transversaux successifs à l'aplomb du câble 14 le long du segment de câble 14 sélectionné, par exemple selon un tracé en boustrophédon, notamment suite à l'étape 108. Au cours de ce trajet T, le dispositif 60 prend toute une série de mesures M du champ électromagnétique H. Ce trajet T, ponctué de mesures M, est représenté sur la figure 11. De ces mesures sont déduites des valeurs successives du module |H| du champ électromagnétique et éventuellement de sa composante verticale |Hz|. Sur la figure 11, c'est le module |H| qui est représenté par des points d'autant plus larges que la valeur de |H| est élevée. Ainsi, le passage à l'aplomb du câble 14 peut être détecté, soit par un maximum local du module |H|, soit par un minimum local de |Hz|, soit par une corrélation entre des maxima et minima locaux du module |H| et de |Hz|, dans la succession des mesures M.

De cette manière, lors d'une étape 202, on en déduit des mesures M les points de passage à l'aplomb du câble positionnés le long d'une droite parallèle à l'axe x de la figure 9. Grâce aux mesures M relevées en ces points de passage, il est possible de constituer une courbe de points, le long du segment de câble 14 sélectionné, pour lesquels une valeur du module |H| du champ électromagnétique est connue. Comme indiqué précédemment en référence à la figure 9 (courbe de droite), cette courbe de points, éventuellement interpolée, présente un point d'inflexion à l'aplomb du défaut 26.

Ce point d'inflexion est déterminé par l'ordinateur 74 selon une méthode classique qui ne sera pas détaillée, lors d'une étape 204.

Enfin, lors d'une dernière étape 206, une estimation de la position du défaut 26 sur le câble 14 est retournée, en fonction du point d'inflexion déterminé.

En variante, on notera que l'on peut se passer de l'étape 200, consistant à suivre un trajet selon un tracé en boustrophédon, si l'on connaît bien la position exacte du câble et si l'on est capable de suivre un trajet directement le long du câble à son aplomb. Dans ce cas, lors de l'étape 202, on relève directement des mesures du module |H| à l'aplomb du câble en le suivant sur la longueur du segment de câble 14 sélectionné pour obtenir la courbe de points représentée en figure 9 (courbe de droite).

L'homme de l'art notera que l'invention est indépendante de la réalisation de la pré-localisation. Il apparaît clairement qu'un procédé tel que celui décrit précédemment selon plusieurs aspects, variantes et modes de réalisation, permet d'assurer une mesure précise de la localisation dans un câble électrique, ou un ensemble de câbles électriques, d'un défaut générateur de réflexion au moins partielle d'un signal électrique incident.

On notera également que l'invention n'est pas limitée aux modes de réalisation décrits et illustrés. Elle est notamment susceptible de diverses variantes, quant à l'installation de transmission d'énergie électrique à laquelle elle s'applique ou au modèle de variation de vitesse de propagation utilisé, que ce modèle se déduise de mesures et/ou d'une étude analytique et/ou d'une analyse numérique.

Annexe

| Tableau 1 : mesure depuis l'extrémité de Sangatte 18 | | |
|---|---|---|
| L (en m) | $\theta_0$ (en $\mu$s) | $\theta_{10\%}$ (en $\mu$s) |
| 0.000 | 0 | 0 |
| 0.400 | 5,20 | Montée rapide du signal |
| 0.800 | 10,43 | 10,65 |
| 1.200 | 15,68 | 16,05 |
| 1.600 | 20,95 | 21,47 |
| 2.000 | 26,24 | 26,92 |
| 2.400 | 31,54 | 32,37 |
| 2.800 | 36,86 | 37,84 |
| 3.200 | 42,19 | 43,31 |
| 3.600 | 47,54 | 48,79 |
| 4.000 | 52,88 | 54,28 |
| 4.400 | 58,21 | 59,77 |
| 4.800 | 63,58 | 65,26 |
| 5.200 | 68,94 | 70,76 |
| 5.600 | 74,32 | 76,26 |
| 6.000 | 79,7 | 81,76 |

(suite)

| Tableau 1 : mesure depuis l'extrémité de Sangatte 18 | | |
|---|---|---|
| L (en m) | $\theta_0$ (en µs) | $\theta_{10\%}$ (en µs) |
| 6.400 | 85,08 | 87,27 |
| 6.800 | 90,47 | 92,78 |
| 7.200 | 95,88 | 98,29 |
| 7.600 | 101,27 | 103,81 |
| 8.000 | 106,65 | 109,33 |
| 8.400 | 112,05 | 114,84 |
| 8.800 | 117,45 | 120,36 |
| 9.200 | 122,84 | 125,88 |
| 9.600 | 128,23 | 131,41 |
| 10.000 | 133,67 | 136,93 |
| 10.400 | 139,09 | 142,38 |
| 10.800 | 144,50 | 147,94 |
| 11.200 | 149,93 | 153,52 |
| 11.600 | 155,32 | 159,06 |
| 12.000 | 160,77 | 164,60 |
| 12.400 | 166,21 | 170,13 |
| 12.800 | 171,65 | 175,67 |
| 13.200 | 177,10 | 181,21 |
| 13.600 | 182,52 | 186,76 |
| 14.000 | 187,96 | 192,30 |
| 14.400 | 193,44 | 197,85 |
| 14.800 | 198,87 | 203,39 |
| 15.200 | 204,35 | 208,94 |
| 15.600 | 209,79 | 214,49 |
| 16.000 | 215,28 | 220,03 |
| 16.400 | 220,69 | 225,60 |
| 16.800 | 226,14 | 231,15 |
| 17.200 | 231,58 | 236,71 |
| 17.600 | 237,03 | 242,26 |
| 18.000 | 242,52 | 247,82 |
| 18.400 | 247,97 | 253,38 |
| 18.800 | 253,43 | 258,95 |
| 19.200 | 258,89 | 264,51 |
| 19.600 | 264,40 | 270,07 |
| 20.000 | 269,83 | 275,64 |
| 20.400 | 275,30 | 281,21 |
| 20.800 | 280,77 | 286,77 |

(suite)

| Tableau 1 : mesure depuis l'extrémité de Sangatte 18 | | |
|---|---|---|
| L (en m) | $\theta_0$ (en µs) | $\theta_{10\%}$ (en µs) |
| 21.200 | 286,25 | 292,34 |
| 21.600 | 291,73 | 297,91 |
| 22.000 | 297,17 | 303,48 |
| 22.400 | 302,62 | 309,05 |
| 22.800 | 308,10 | 314,63 |
| 23.200 | 313,55 | 320,20 |
| 23.600 | 319,00 | 325,78 |
| 24.000 | 324,45 | 331,35 |
| 24.400 | 329,95 | 336,55 |
| 24.800 | 335,45 | 342,51 |
| 25.200 | 340,90 | 348,09 |
| 25.600 | 346,41 | 353,67 |
| 26.000 | 351,87 | 359,26 |
| 26.400 | 357,38 | 364,84 |
| 26.800 | 362,84 | 370,42 |
| 27.200 | 368,36 | 376,01 |
| 27.600 | 373,88 | 381,59 |
| 28.000 | 379,35 | 387,18 |
| 28.400 | 384,82 | 392,77 |
| 28.800 | 390,29 | 398,36 |
| 29.200 | 395,77 | 403,95 |
| 29.600 | 401,30 | 409,54 |
| 30.000 | 406,83 | 415,14 |
| 30.400 | 412,31 | 420,74 |
| 30.800 | 417,79 | 426,33 |
| 31.200 | 423,28 | 431,92 |
| 31.600 | 428,76 | 437,52 |
| 32.000 | 434,25 | 443,11 |
| 32.400 | 439,73 | 448,71 |
| 32.800 | 445,22 | 454,31 |
| 33.200 | 450,71 | 459,91 |
| 33.600 | 456,27 | 465,51 |
| 34.000 | 461,76 | 471,12 |
| 34.400 | 467,26 | 476,72 |
| 34.800 | 472,76 | 482,33 |
| 35.200 | 478,26 | 487,93 |
| 35.600 | 483,76 | 493,53 |

(suite)

| Tableau 1 : mesure depuis l'extrémité de Sangatte 18 | | |
|---|---|---|
| L (en m) | $\theta_0$ (en $\mu$s) | $\theta_{10\%}$ (en $\mu$s) |
| 36.000 | 489,32 | 499,14 |
| 36.400 | 494,83 | 504,75 |
| 36.800 | 500,40 | 510,35 |
| 37.200 | 505,91 | 515,96 |
| 37.600 | 511,42 | 521,57 |
| 38.000 | 516,93 | 527,19 |
| 38.400 | 522,44 | 532,80 |
| 38.800 | 527,96 | 538,41 |
| 39.200 | 533,40 | 544,02 |
| 39.600 | 538,92 | 549,64 |
| 40.000 | 544,43 | 555,25 |
| 40.400 | 549,88 | 560,86 |
| 40.800 | 555,40 | 566,48 |
| 41.200 | 561,00 | 572,10 |
| 41.600 | 566,52 | 577,72 |
| 42.000 | 572,05 | 583,34 |
| 42.400 | 577,57 | 588,96 |
| 42.800 | 583,10 | 594,58 |
| 43.200 | 588,63 | 600,20 |
| 43.600 | 594,16 | 605,82 |
| 44.000 | 599,61 | 611,44 |
| 44.400 | 605,15 | 617,07 |
| 44.800 | 610,68 | 622,69 |
| 45.200 | 616,22 | 628,31 |
| 45.600 | 621,76 | 633,94 |
| 46.000 | 627,30 | 639,56 |
| 46.400 | 632,84 | 645,19 |
| 46.800 | 638,38 | 650,82 |
| 47.200 | 643,92 | 656,45 |
| 47.600 | 649,47 | 662,08 |
| 48.000 | 655,02 | 667,70 |

| Tableau 2 : mesure depuis l'extrémité de Sellindge 16 | | |
|---|---|---|
| L (en m) | $\theta_0$ (en $\mu$s) | $\theta_{10\%}$ (en $\mu$s) |
| 0.000 | 245,35 | - |
| 0.400 | 251,06 | 263,22 |

(suite)

| Tableau 2 : mesure depuis l'extrémité de Sellindge 16 | | |
|---|---|---|
| L (en m) | $\theta_0$ (en $\mu$s) | $\theta_{10\%}$ (en $\mu$s) |
| 0.800 | 256,68 | 270,26 |
| 1.200 | 262,35 | 276,47 |
| 1.600 | 268,00 | 282,09 |
| 2.000 | 273,62 | 287,43 |
| 2.400 | 279,22 | 292,66 |
| 2.800 | 284,75 | 297,85 |
| 3.200 | 290,37 | 303,11 |
| 3.600 | 295,81 | 308,39 |
| 4.000 | 301,40 | 313,76 |
| 4.400 | 306,97 | 319,20 |
| 4.800 | 312,45 | 324,70 |
| 5.200 | 318,03 | 330,22 |
| 5.600 | 323,57 | 335,75 |
| 6.000 | 329,07 | 341,32 |
| 6.400 | 334,63 | 346,92 |
| 6.800 | 340,19 | 352,53 |
| 7.200 | 345,75 | 358,14 |
| 7.600 | 351,27 | 363,75 |
| 8.000 | 356,80 | 369,41 |
| 8.400 | 362,38 | 375,04 |
| 8.800 | 367,87 | 380,68 |
| 9.200 | 373,41 | 386,33 |
| 9.600 | 379,01 | 391,97 |
| 10.000 | 384,51 | 397,64 |
| 10.400 | 390,01 | 403,26 |
| 10.800 | 395,57 | 408,89 |
| 11.200 | 401,18 | 414,52 |
| 11.600 | 406,75 | 420,16 |
| 12.000 | 412,27 | 425,80 |
| 12.400 | 417,73 | 431,45 |
| 12.800 | 423,25 | 437,08 |
| 13.200 | 428,78 | 442,73 |
| 13.600 | 434,31 | 448,38 |
| 14.000 | 439,84 | 454,02 |
| 14.400 | 445,43 | 459,67 |
| 14.800 | 450,97 | 465,33 |
| 15.200 | 456,51 | 470,98 |

(suite)

| Tableau 2 : mesure depuis l'extrémité de Sellindge 16 | | |
|---|---|---|
| L (en m) | $\theta_0$ (en $\mu$s) | $\theta_{10\%}$ (en $\mu$s) |
| 15.600 | 462,05 | 476,63 |
| 16.000 | 467,54 | 482,29 |
| 16.400 | 473,15 | 487,94 |
| 16.800 | 478,70 | 493,60 |
| 17.200 | 484,26 | 499,26 |
| 17.600 | 489,75 | 504,88 |
| 18.000 | 495,31 | 510,57 |
| 18.400 | 500,86 | 516,23 |
| 18.800 | 506,44 | 521,90 |
| 19.200 | 512,01 | 527,56 |
| 19.600 | 517,52 | 533,23 |
| 20.000 | 523,09 | 538,87 |
| 20.400 | 528,53 | 544,52 |
| 20.800 | 534,03 | 550,22 |
| 21.200 | 539,54 | 555,89 |
| 21.600 | 545,13 | 561,56 |
| 22.000 | 550,64 | 567,22 |
| 22.400 | 556,23 | 572,85 |
| 22.800 | 561,75 | 578,60 |
| 23.200 | 567,26 | 584,23 |
| 23.600 | 572,78 | 589,90 |
| 24.000 | 578,30 | 595,57 |
| 24.400 | 583,83 | 601,25 |
| 24.800 | 589,35 | 606,91 |
| 25.200 | 594,96 | 612,60 |
| 25.600 | 600,49 | 618,24 |
| 26.000 | 606,01 | 623,95 |
| 26.400 | 611,54 | 629,62 |
| 26.800 | 617,08 | 635,30 |
| 27.200 | 622,61 | 640,93 |
| 27.600 | 628,15 | 646,61 |
| 28.000 | 633,68 | 652,28 |
| 28.400 | 639,22 | 657,97 |
| 28.800 | 644,76 | 663,55 |
| 29.200 | 650,39 | 669,24 |
| 29.600 | 656,02 | 674,92 |
| 30.000 | 661,57 | 680,57 |

(suite)

| Tableau 2 : mesure depuis l'extrémité de Sellindge 16 | | |
|---|---|---|
| L (en m) | $\theta_0$ (en $\mu$s) | $\theta_{10\%}$ (en $\mu$s) |
| 30.400 | 667,12 | 686,24 |
| 30.800 | 672,57 | 691,91 |
| 31.200 | 678,12 | 697,61 |
| 31.600 | 683,67 | 703,28 |
| 32.000 | 689,13 | 708,95 |
| 32.400 | 694,69 | 714,60 |
| 32.800 | 700,24 | 720,33 |
| 33.200 | 705,89 | 726,00 |
| 33.600 | 711,45 | 731,62 |
| 34.000 | 717,01 | 737,27 |
| 34.400 | 722,57 | 742,97 |
| 34.800 | 728,04 | 748,69 |
| 35.200 | 733,60 | 754,33 |
| 35.600 | 739,07 | 760,05 |
| 36.000 | 744,63 | 765,73 |
| 36.400 | 750,10 | 771,41 |
| 36.800 | 755,67 | 777,12 |
| 37.200 | 761,13 | 782,81 |
| 37.600 | 766,70 | 788,38 |
| 38.000 | 772,27 | 794,15 |
| 38.400 | 777,85 | 799,69 |
| 38.800 | 783,42 | 805,38 |
| 39.200 | 789,00 | 811,05 |
| 39.600 | 794,58 | 816,74 |
| 40.000 | 800,16 | 822,42 |
| 40.400 | 805,63 | 828,08 |
| 40.800 | 811,21 | 833,82 |
| 41.200 | 816,68 | 839,43 |
| 41.600 | 822,16 | 845,12 |
| 42.000 | 827,74 | 850,79 |
| 42.400 | 833,21 | 856,47 |
| 42.800 | 838,69 | 862,17 |
| 43.200 | 844,28 | 867,84 |
| 43.600 | 849,75 | 873,54 |
| 44.000 | 855,22 | 879,23 |
| 44.400 | 860,81 | 884,90 |
| 44.800 | 866,29 | 890,60 |

(suite)

| Tableau 2 : mesure depuis l'extrémité de Sellindge 16 | | |
|---|---|---|
| L (en m) | $\theta_0$ (en $\mu$s) | $\theta_{10\%}$ (en $\mu$s) |
| 45.200 | 871,88 | 896,34 |
| 45.600 | 877,48 | 901,97 |
| 46.000 | 882,95 | 907,65 |
| 46.400 | 888,55 | 913,40 |
| 46.800 | 894,15 | 919,14 |
| 47.200 | 899,63 | 924,67 |
| 47.600 | 905,23 | 930,41 |
| 48.000 | 910,70 | 936,10 |

**Revendications**

1. Procédé de localisation d'un défaut (26) sur une liaison électrique (12, 14), **caractérisé en ce qu'**il comprend les étapes consistant à :

- mesurer (200), à l'aide d'un système (68) à trois bobines orthogonales entre elles, trois composantes orthogonales d'un champ électromagnétique (H) engendré par la liaison électrique à l'endroit où le système (68) est disposé, au voisinage d'une localisation préalable estimée du défaut (26) à plusieurs endroits le long de la liaison (12, 14),
- estimer le module complet (|H|) dudit champ électromagnétique (H) à partir de ces trois composantes mesurées en chacun desdits endroits le long de la liaison (12, 14),
- en déduire (202) une estimation d'une courbe représentant la variation du module complet (|H|) dudit champ électromagnétique (H) le long de la liaison électrique (12, 14) au voisinage de la localisation préalable estimée du défaut (26),
- estimer (204) une nouvelle localisation du défaut (26) en fonction de cette courbe.

2. Procédé de localisation d'un défaut (26) sur une liaison électrique (12, 14) selon la revendication 1, dans lequel l'estimation (204) d'une nouvelle localisation du défaut (26) comporte la détection d'un point d'inflexion dans la courbe représentative de la variation du module complet (|H|) dudit champ électromagnétique le long de la liaison (12, 14).

3. Procédé de localisation d'un défaut (26) sur une liaison électrique (12, 14) selon la revendication 1 ou 2, dans lequel les mesures (M), à plusieurs endroits le long de la liaison (12, 14), des trois composantes orthogonales dudit champ électromagnétique (H) sont réalisées selon un trajet (T) constitué de passages transversaux successifs à l'aplomb de la liaison (12, 14), notamment selon un tracé en boustrophédon, les passages à l'aplomb de la liaison étant détectés par des maxima locaux du module complet (|H|) dudit champ électromagnétique (H) dans la succession des mesures (M) et la courbe représentative de la variation du module complet (|H|) dudit champ électromagnétique (H) le long de la liaison étant constituée de l'ensemble desdits maxima locaux.

4. Procédé de localisation d'un défaut (26) sur une liaison électrique (12, 14) selon la revendication 3, comportant les étapes consistant à :

- prendre (200) une série de mesures (M) dont sont déduites des valeurs du module complet (|H|) du champ électromagnétique (H) sur ledit trajet (T),
- déduire (202) de ces mesures (M) des points de passage à l'aplomb de la liaison électrique (12, 14) en détectant des maxima locaux dans la succession des mesures (M), et en constituer une courbe de points, le long de la liaison électrique (12, 14), pour lesquels une valeur du module complet (|H|) du champ électromagnétique (H) est connue,
- déterminer (204) un point d'inflexion de cette courbe de points et retourner (206) une estimation de la localisation du défaut (26) sur la liaison électrique (12, 14) en fonction du point d'inflexion déterminé.

**5.** Procédé de localisation d'un défaut (26) sur une liaison électrique (12, 14) selon l'une quelconque des revendications 1 à 4, dans lequel le champ électromagnétique (H) mesuré est généré par la circulation dans la liaison électrique (12, 14) d'un courant (i) de fréquence prédéterminée et dans lequel la partie mesurée des composantes du champ électromagnétique (H) est filtrée à l'aide d'un système de filtrage passe-bande (70) réglé autour de cette fréquence prédéterminée du courant (i).

**6.** Procédé de localisation d'un défaut (26) sur une liaison électrique (12, 14) selon l'une quelconque des revendications 1 à 5, comprenant en outre les étapes préalables consistant à :

- établir un modèle de variation de la vitesse (V) de propagation du signal électrique dans la liaison électrique (12, 14) en fonction de la longueur de liaison électrique parcourue par le signal,
- émettre (100, 100'), à un premier instant, un signal électrique à vitesse prédéterminée de propagation au départ d'une extrémité (16, 18) de la liaison électrique (12, 14),
- détecter (102, 102'), à un second instant, la réception d'un écho de ce signal électrique,
- estimer (104, 104') la localisation préalable du défaut en fonction de la différence entre les premier et second instants, de la vitesse prédéterminée de propagation au départ et du modèle de variation de vitesse dans la liaison (12, 14).

**7.** Procédé de localisation d'un défaut (26) sur une liaison électrique (12, 14) selon la revendication 6, comportant une étape consistant à définir, à l'aide du modèle de variation de la vitesse (V) de propagation du signal électrique dans la liaison électrique (12, 14), un tableau de correspondance entre, d'une part, des valeurs de différence entre les premier et second instants et, d'autre part, des distances supposées du défaut (26) à un point de référence (16, 18, 20) de la liaison électrique (12, 14).

**8.** Procédé de localisation d'un défaut (26) sur une liaison électrique (12, 14) selon la revendication 6 ou 7, dans lequel le modèle de variation de la vitesse (V) de propagation du signal électrique dans la liaison électrique (12, 14) est un modèle à facteur de pertes diélectriques et à permittivité diélectrique d'un isolant (44) de la liaison (12, 14) variables en fonction d'une fréquence du signal, et par conséquent de la longueur de liaison électrique parcourue par le signal, induisant une diminution de la vitesse de propagation (V) du signal.

**9.** Procédé de localisation d'un défaut (26) sur une liaison électrique (12, 14) selon l'une quelconque des revendications 6 à 8, dans lequel la réception (102, 102'), au second instant, de l'écho du signal électrique est déterminée lorsque l'amplitude de cet écho atteint un pourcentage prédéterminé, notamment dix pourcents, de son amplitude maximale.

**10.** Dispositif (60) de localisation d'un défaut (26) sur une liaison électrique (12, 14), **caractérisé en ce qu'**il comporte :

- trois bobines (68), orthogonales entre elles, de mesure de trois composantes orthogonales d'un champ électromagnétique (H) engendré par la liaison électrique à l'endroit où le dispositif de localisation est disposé, au voisinage d'une localisation préalable estimée du défaut (26) à plusieurs endroits le long de la liaison (12, 14),
- des moyens d'estimation du module complet (|H|) dudit champ électromagnétique (H) à partir de ces trois composantes mesurées en chacun desdits endroits le long de la liaison (12, 14),
- des moyens (74) d'estimation d'une courbe représentant la variation du module complet (|H|) dudit champ électromagnétique (H) le long de la liaison électrique (12, 14) au voisinage de la localisation préalable estimée du défaut (26), à partir de la mesure desdites trois composantes orthogonales le long de la liaison (12, 14),
- des moyens (74) d'estimation d'une nouvelle localisation du défaut (26) en fonction de cette courbe

**Patentansprüche**

**1.** Verfahren zur Lokalisierung eines Fehlers (26) in einer elektrischen Verbindung (12, 14), **dadurch gekennzeichnet, dass** es die folgenden Schritte umfasst:

- Messen (200), mit Hilfe eines Systems (68) aus drei zueinander orthogonalen Spulen, von drei orthogonalen Komponenten eines elektromagnetischen Felds (H), das durch die elektrische Verbindung an der Stelle erzeugt wird, wo das System (68) angeordnet ist, in der Nähe einer zuvor geschätzten Lokalisierung des Fehlers (26) an mehreren Stellen entlang der Verbindung (12, 14),
- Schätzen des vollständigen Moduls (|H|) des elektromagnetischen Felds (H) auf der Basis dieser drei, an jeder der Stellen entlang der Verbindung (12, 14) gemessenen Komponenten,

- Ableiten (202) daraus einer Schätzung einer Kurve, die die Schwankung des vollständigen Moduls (|H|) des elektromagnetischen Felds (H) entlang der elektrischen Verbindung (12, 14) in der Nähe der zuvor geschätzten Lokalisierung des Fehlers (26) darstellt,
- Schätzen (204) einer neuen Lokalisierung des Fehlers (26) in Abhängigkeit von dieser Kurve.

2. Verfahren zur Lokalisierung eines Fehlers (26) in einer elektrischen Verbindung (12, 14) nach Anspruch 1, wobei die Schätzung (204) einer neuen Lokalisierung des Fehlers (26) die Erkennung eines Krümmungspunkts in der repräsentativen Kurve der Schwankung des vollständigen Moduls (|H|) des elektromagnetischen Felds (H) entlang der Verbindung (12, 14) aufweist.

3. Verfahren zur Lokalisierung eines Fehlers (26) in einer elektrischen Verbindung (12, 14) nach Anspruch 1 oder 2, wobei die Messungen (M) an mehreren Stellen entlang der Verbindung (12, 14) der drei orthogonalen Komponenten des elektromagnetischen Felds (H) gemäß einem Weg (T) durchgeführt werden, der von aufeinanderfolgenden transversalen Durchgängen senkrecht zu der Verbindung (12, 14), insbesondere gemäß einem furchenwendigen Verlauf, durchgeführt werden, wobei die Durchgänge senkrecht zu der Verbindung durch lokale Maxima des vollständigen Moduls (|H|) des elektromagnetischen Felds (H) in der Abfolge der Messungen (M) erkannt werden und die repräsentative Kurve der Schwankung des vollständigen Moduls (|H|) des elektromagnetischen Felds (H) entlang der elektrischen Verbindung (12, 14) von allen lokalen Maxima gebildet wird.

4. Verfahren zur Lokalisierung eines Fehlers (26) in einer elektrischen Verbindung (12, 14) nach Anspruch 3, aufweisend die Schritte, die darin bestehen:

- Durchführen (200) einer Reihe von Messungen (M), aus denen Werte des vollständigen Moduls (|H|) des elektromagnetischen Felds (H) auf dem Weg (T) abgeleitet werden,
- Ableiten (202), aus diesen Messungen (M), der Durchgangspunkte senkrecht zu der elektrischen Verbindung (12, 14), durch Ermitteln der lokalen Maxima in der Abfolge der Messungen (M), und durch Bilden daraus einer Kurve von Punkten entlang der elektrischen Verbindung (12, 14), für die ein Wert des vollständigen Moduls (|H|) des elektromagnetischen Felds (H) bekannt ist,
- Bestimmen (204) eines Krümmungspunkts dieser Punktekurve und Rückführen (206) einer Schätzung der Lokalisierung des Fehlers (26) in der elektrischen Verbindung (12, 14) in Abhängigkeit von dem bestimmten Krümmungspunkt.

5. Verfahren zur Lokalisierung eines Fehlers (26) in einer elektrischen Verbindung (12, 14) nach einem der Ansprüche 1 bis 4, wobei das gemessene elektromagnetische Feld (H) durch die Zirkulation in der elektrischen Verbindung (12, 14) eines Stroms (i) mit einer vorbestimmten Frequenz erzeugt wird und wobei der gemessene Teil der Komponenten des elektromagnetischen Felds (H) mit Hilfe eines um diese vorbestimmte Frequenz des Stroms (i) eingestellten Bandpassfiltersystems (70) gefiltert wird.

6. Verfahren zur Lokalisierung eines Fehlers (26) in einer elektrischen Verbindung (12, 14) nach einem der Ansprüche 1 bis 5, umfassend ferner die vorherigen Schritte, die darin bestehen:

- Festlegen eines Schwankungsmodells der Ausbreitungsgeschwindigkeit (V) des elektrischen Signals in der elektrischen Verbindung (12, 14) in Abhängigkeit von der von dem Signal durchlaufenen Länge der elektrischen Verbindung,
- Senden (100, 100'), in einem ersten Moment, eines elektrischen Signals mit vorbestimmter Ausbreitungsgeschwindigkeit am Start ab einem Ende (16, 18) der elektrischen Verbindung (12, 14),
- Erkennen (102, 102'), in einem zweiten Moment, den Empfang eines Echos dieses elektrischen Signals,
- Schätzen (104, 104') der vorherigen Lokalisierung des Fehlers in Abhängigkeit von der Differenz zwischen dem ersten und zweiten Moment, der vorbestimmten Ausbreitungsgeschwindigkeit am Start und des Schwankungsmodells der Geschwindigkeit in der Verbindung (12, 14) .

7. Verfahren zur Lokalisierung eines Fehlers (26) in einer elektrischen Verbindung (12, 14) nach Anspruch 6, aufweisend einen Schritt, der darin besteht, mit Hilfe des Schwankungsmodells der Ausbreitungsgeschwindigkeit (V) des elektrischen Signals in der elektrischen Verbindung (12, 14) eine Übereinstimmungstabelle zwischen zum einen Differenzwerten zwischen dem ersten und zweiten Moment und zum anderen angenommenen Abständen des Fehlers (26) zu einem Bezugspunkt (16, 18, 20) der elektrischen Verbindung (12, 14) festzulegen.

8. Verfahren zur Lokalisierung eines Fehlers (26) in einer elektrischen Verbindung (12, 14) nach Anspruch 6 oder 7, wobei das Schwankungsmodell der Ausbreitungsgeschwindigkeit (V) des elektrischen Signals in der elektrischen Verbindung (12, 14) ein Modell mit dielektrischem Verlustfaktor und dielektrischer Permittivität eines Isoliermaterials (44) der Verbindung (12, 14) ist, die in Abhängigkeit von einer Frequenz des Signals und folglich von der von dem Signal durchlaufenen Länge der elektrischen Verbindung schwanken, was zu einer Verringerung der Ausbreitungsgeschwindigkeit (V) des Signals führt.

9. Verfahren zur Lokalisierung eines Fehlers (26) in einer elektrischen Verbindung (12, 14) nach einem der Ansprüche 6 bis 8, wobei der Empfang (102, 102'), im zweiten Moment, des Echos des elektrischen Signals bestimmt wird, wenn die Amplitude dieses Echos einen vorbestimmten Prozentsatz, insbesondere zehn Prozent, seiner maximalen Amplitude erreicht.

10. Vorrichtung (60) zur Lokalisierung eines Fehlers (26) in einer elektrischen Verbindung (12, 14), **dadurch gekennzeichnet, dass** sie aufweist:

   - drei zueinander orthogonale Spulen (68) zum Messen von drei orthogonalen Komponenten eines elektromagnetischen Felds (H), das durch die elektrische Verbindung an der Stelle erzeugt wird, wo die Lokalisierungsvorrichtung angeordnet ist, in der Nähe einer zuvor geschätzten Lokalisierung des Fehlers (26) an mehreren Stellen entlang der Verbindung (12, 14),
   - Mittel zum Schätzen des vollständigen Moduls (|H|) des elektromagnetischen Felds (H) auf der Basis dieser drei, an jeder der Stellen entlang der Verbindung (12, 14) gemessenen Komponenten,
   - Mittel (74) zum Schätzen einer Kurve, welche die Schwankung des vollständigen Moduls (|H|) des elektromagnetischen Felds (H) entlang der elektrischen Verbindung (12, 14) in der Nähe der zuvor geschätzten Lokalisierung des Fehlers (26) auf der Basis der Messung der drei orthogonalen Komponenten entlang der Verbindung (12, 14) darstellt,
   - Mittel (74) zum Schätzen einer neuen Lokalisierung des Fehlers (26) in Abhängigkeit von dieser Kurve.

## Claims

1. Method for locating a defect (26) on an electric link (12, 14), **characterized in that** it comprises the steps consisting of:

   - measuring (200), by means of a system (68) with three mutually orthogonal coils, three orthogonal components of an electromagnetic field (H) generated by the electric link where the system (68) is placed, in the vicinity of an estimated prior location of the defect (26) at several places along the link (12, 14),
   - estimating the complete module (IHI) of said electromagnetic field (H) based on these three components measured in each of said places along the link (12, 14),
   - deducing from this (202) an estimation of a curve that represents the variation of the complete module (|H|) of said electromagnetic field (H) along the link (12, 14) in the vicinity of the estimated prior location of the defect (26),
   - estimating (204) a new location of the defect (26) as a function of this curve.

2. Method for locating a defect (26) on an electric link (12, 14) according to claim 1, wherein estimating (204) a new location of the defect (26) comprises detecting an inflexion point in the curve that represents the variation of the complete module (|H|) of said electromagnetic field along the link (12, 14).

3. Method for locating a defect (26) on an electric link (12, 14) according to claim 1 or 2, wherein the measurements (M), at several places along the link (12, 14), of the three orthogonal components of said electromagnetic field (H) are carried out along a path (T) constituted of successive transversal passages directly above the link (12, 14), particularly along a boustrophedon course, the passages directly above the link being detected by local maxima of the complete module (|H|) of said electromagnetic field (H) in the succession of measurements (M) and the representative curve of the variation of the complete module (|H|) of said electromagnetic field (H) along the link being constituted of all of said local maxima.

4. Method for locating a defect (26) on an electric link (12, 14) according to claim 3, comprising the steps consisting of:

   - carrying out (200) a series of measurements (M) from which values of the complete module (|H|) of the electromagnetic field (H) on said path (T) are deduced,
   - deducing (202) from these measurements (M) points of passage directly above the electric link (12, 14) by detecting local maxima in the succession of measurements (M), and constitute from this a curve of points, along the electric link (12, 14), for which a value of the complete module (|H|) of the electromagnetic field (H) is known,
- determining (204) an inflexion point in this curve of points and return (206) an estimation of the default (26) location on the electric link (12, 14) as a function of the determined inflexion point.

5. Method for locating a defect (26) on an electric link (12, 14) according to any of claims 1 to 4, wherein the measured electromagnetic field (H) is generated by the flow in the electric link (12, 14) of a current (i) of predetermined frequency and wherein the measured part of the components of the electromagnetic field (H) is filtered by means of a band-pass filtering system (70) tuned around this predetermined frequency of the current (i).

6. Method for locating a defect (26) on an electric link (12, 14) according to any of claims 1 to 5, further comprising the prior steps consisting of:

   - establishing a model of variation of the electric signal propagation speed (V) in the electric link (12, 14) as a function of the length of electric link through which the signal has flowed,
   - transmitting (100, 100'), at a first moment, an electric signal having a predetermined propagation speed at the start from an end (16, 18) of the electric link (12, 14),
   - detecting (102, 102'), at a second moment, the reception of an echo of said electric signal,
   - estimating (104, 104') the prior location of the defect as a function of the difference between the first and second moments, of the predetermined propagation speed at the start, and of the speed variation model in the link (12, 14).

7. Method for locating a defect (26) on an electric link (12, 14) according to claim 6, comprising a step consisting of defining, by means of the model of the variation of the electric signal propagation speed (V) in the electric link (12, 14), a correspondence table between, on the one hand, difference values between the first and second moments and, on the other hand, assumed distances from the defect (26) to a reference point (16, 18, 20) of the electric link (12, 14).

8. Method for locating a defect (26) on an electric link (12, 14) according to claim 6 or 7, wherein the model of the variation of the electric signal propagation speed (V) in the electric link (12, 14) is a model with dielectric loss factor and with dielectric permittivity of an insulator (44) of the link (12, 14) that are variable as a function of a frequency of the signal, and consequently of the length of electric link through which the signal has flowed, inducing a reduction in the signal propagation speed (V).

9. Method for locating a defect (26) on an electric link (12, 14) according to any of claims 6 to 8, wherein the reception (102, 102'), at the second moment, of the echo of the electric signal is determined when the amplitude of this echo attains a predetermined percentage, particularly ten percent, of its maximal amplitude.

10. Device (60) for locating a defect (26) on an electric link (12, 14), **characterized in that** it includes:

   - three coils (68), mutually orthogonal, for measuring three orthogonal components of an electromagnetic field (H) generated by the electric link where the device for locating is placed, in the vicinity of an estimated prior location of the defect (26) at several places along the link (12, 14),
   - means for estimating the complete module (|H|) of said electromagnetic field (H) based on these three components measured in each of said places along the link (12, 14),
   - means (74) for estimating a curve that represents the variation of the complete module (|H|) of said electromagnetic field (H) along the electric link (12, 14) in the vicinity of the estimated prior location of the defect (26), based on the measurement of said three orthogonal components along the link (12, 14),
   - means (74) for estimating a new location of the defect (26) as a function of this curve

## Figure 1

## Figure 2

## Figure 3a

## Figure 3b

## Figure 4a

## Figure 4b

## Figure 5

## Figure 6

## Figure 7

## Figure 8

## Figure 9

## Figure 10

## Figure 11

**RÉFÉRENCES CITÉES DANS LA DESCRIPTION**

**Documents brevets cités dans la description**

- FR 2784192
- US 20020130668 A
- US 20060232259 A